# EUROPEAN PATENT SPECIFICATION

(11) **EP 3 431 364 B1**
(45) Date of publication and mention of the grant of the patent: **30.12.2020**
(21) Application number: 16894303.3
(22) Date of filing: 14.03.2016
(51) Int. Cl.: B60R 16/02, B62D 5/04, H01F 27/00, H01G 4/40, H03H 7/01, B60R 16/03

(54) **ELECTRIC POWER STEERING DEVICE**
ELEKTRISCHE SERVOLENKVORRICHTUNG
DISPOSITIF DE DIRECTION ASSISTÉE ÉLECTRIQUE

(43) Date of publication of application: 23.01.2019
(73) Proprietor: Mitsubishi Electric Corporation, Chiyoda-ku Tokyo 100-8310 (JP)
(72) Inventor: URIMOTO Kentaro, Tokyo 100-8310 (JP); NAGASHIMA Tomohiko, Tokyo 100-8310 (JP); ASAO Yoshihito, Tokyo 100-8310 (JP)
(74) Representative: Hoffmann Eitle
(86) International application number: PCT/JP2016/057963
(87) International publication number: WO 2017/158679

(56) References cited:
- WO-A1-2013/132584
- WO-A1-2015/049791
- WO-A1-2015/049791
- WO-A1-2015/145630
- JP-A- H0 661 054
- JP-A- H03 286 516
- JP-A- H03 286 516
- JP-U- S5 769 324
- US-A1- 2016 036 304
- US-A1- 2016 072 423

## Description

### Technical Field

This invention relates to an electric power steering device that assists a driving force of a steering mechanism for a vehicle and, in particular, relates to improvement of a placement structure of a filter device in a device in which a motor and a control unit are integrated with each other.

### Background Art

In an existing electric steering device, an electric power steering device having a structure in which a motor including a stator winding and a control unit including an inverter circuit section that drives the stator winding are integrally formed coaxially on the counter-output side of a rotating shaft of the motor is already known (PTL 1). PTL 2 discloses a drive unit and electric power steering including the drive unit.

### Citation List

### Patent Literature

PTL 1: WO 2015/049791A1
PTL 2: US2016/0036304 A1

### Summary of Invention

### Technical Problem

The device disclosed in PTL 1 is a device in which the control unit is placed on the counter-output side of the rotating shaft of the motor and a plurality of connectors and parts of a power supply circuit section (a filter circuit section) are mounted on the outside of a connector case covering the above-described control unit, the device which achieves miniaturization by separately placing the power supply circuit section without placing the power supply circuit section, which is a relatively large part, in the control unit. However, since the parts, such as a capacitor and a coil, of the power supply circuit section are connected by conductive bars for power supply which extend from connectors for power supply to the inside of the control unit, a plurality of through holes have to be formed in the connector case in advance, for example, which leaves room for further improvement of the workability of this portion.

Moreover, for example, the shape of the capacitor generally has a leg portion to be connected (welded) to the conductive bar; in actuality, a part having a shape without a leg portion, such as a ceramic capacitor, also exists, and, when such a part without a leg portion is used, connecting the part to the conductive bar is complicated in terms of work. Furthermore, since the distance of connection with the capacitor affects noise suppression, the shorter the connection distance, the better, and, since the connection path therebetween also affects noise suppression, there are quite a few points that have to be ingeniously improved.

This invention provides an electric power steering device that achieves further improvement of a noise suppression effect and improves workability by devising the configuration of a power supply circuit section (a filter circuit section).

### Solution to Problem

The subject-matter of the independent claims solves the above technical problem, wherein the dependent claims describe further embodiments.

### Advantageous Effects of Invention

According to this invention, as described above, since, near a connector for power supply, a filter module into which filter parts including a bus bar for electric conduction, a coil, and a capacitor are integrated is housed in a control unit, the placement of a filter section and the ease with which the filter section is assembled are enhanced and wiring of the capacitor and the like can be shortened, which makes it possible to achieve further suppression of noise and miniaturization compared to an existing example.

### Brief Description of Drawings

[Fig. 1] Fig. 1 is an overall circuit diagram of an electric power steering device to which this invention is directed.
[Fig. 2] Fig. 2 is a sectional view depicting the overall configuration of an electric power steering device in Embodiment 1 of this invention.
[Figs. 3A and 3B] Figs. 3A and 3B are top views depicting the internal configuration of an area around a filter module section in Embodiment 1 of this invention.
[Fig. 4] Fig. 4 is an overall configuration sectional view of an electric power steering device in Embodiment 2 of this invention.
[Figs. 5A and 5B] Figs. 5A and 5B are top views depicting the internal configuration of an area around a filter module section in Embodiment 2 of this invention.
[Fig. 6] Fig. 6 is an internal configuration diagram of an area around a filter module section in Embodiment 3 of this invention.

### Description of Embodiments

### Embodiment 1.

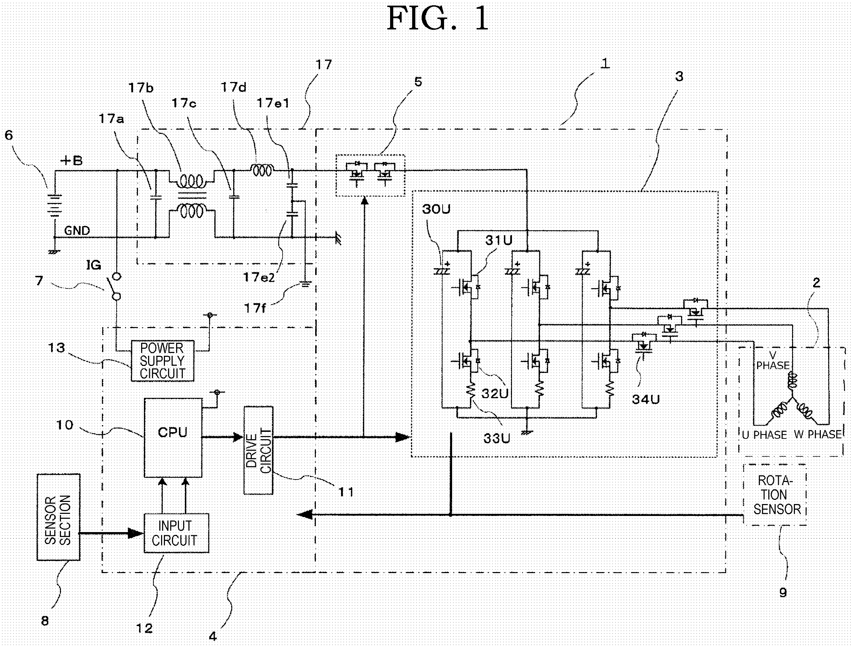

Hereinafter, Embodiment 1 of this invention will be described based on the drawings. Fig. 1 is a circuit configuration diagram of the whole electric power steering device, and 1 denotes a control unit and 2 denotes a three-phase motor. The control unit 1 is mainly configured with a control circuit section 4 incorporating a CPU 10, an inverter circuit section 3 that supplies a current to the motor 2, a relay for power supply 5, and a filter section 17. A power supply +B (a battery power supply line) and GND (a ground line) are connected from a battery 6 mounted on a vehicle, and power is applied by an ignition switch 7 via a power supply circuit 13 of the control circuit section 4.

Furthermore, information of, for example, a torque sensor detecting steering torque, which is mounted near a steering mechanism (a handle) of the vehicle, a speed sensor detecting the traveling speed of the vehicle, and so forth is input from a sensor section 8. The power passing through the filter section 17, which is configured with a common mode coil 17b, a normal mode coil 17d, capacitors (17a, 17c, 17e1, 17e2), and so forth, is a current source of the inverter circuit section 3; however, depending on noise which the device generates, only one of the coils 17b and 17d may be provided and the number of capacitors can also be reduced.

The information from the sensor section 8 is transferred to the processing unit CPU 10 via an input circuit 12 of the control circuit section 4. From these information, the CPU 10 calculates a current value which is a controlled variable for rotating the motor 2 and outputs the current value. This output signal is transferred to a drive circuit 11 constituting an output circuit and to the inverter circuit section 3. Of the output circuit, the drive circuit 11 receives an instruction signal of the CPU 10 and outputs a drive signal that drives switching elements 31 and 32 of the inverter circuit section 3. Since only a small current flows through the drive circuit 11, the drive circuit 11 is placed in the control circuit section 4, but the drive circuit 11 can also be placed in the inverter circuit section 3. The inverter circuit section 3 is mainly configured with the switching elements 31 and 32 for upper and lower arms for three-phase windings (U, V, W) of the motor 2, switching elements 34 for a motor relay, which connect or interrupt wiring between the switching elements 31 and 32 and the motor windings, shunt resistances 33 for current detection, and capacitors for noise suppression 30. The inverter circuit section 3 has the same circuit configuration for the windings of phases and can independently supply a current to the windings of phases.

Moreover, though not depicted in the drawing, a potential difference between the ends of each shunt resistance 33 and, for instance, a voltage of a motor winding terminal are also transferred to the input circuit 12. These information is also input to the CPU 10, and, by calculating a difference between the calculated current value and a corresponding detected value and performing so-called feedback control, the CPU 10 supplies a desired motor current and assists a steering force. Furthermore, the above-described drive circuit 11 also outputs a drive signal of a switching element 5 for a power supply relay, which operates as a relay that connects and interrupts the power supply of the battery +B and the inverter circuit section 3, and this switching element 5 makes it possible to interrupt the supply of a current to the motor itself. The switching elements 34 for a motor relay are also provided in the inverter circuit section 3 and can independently interrupt the phases under abnormal conditions of the phases. It is to be noted that the switching element 5 for a power supply relay may also be included in the inverter circuit section 3 because a large current flows through the switching element 5 for a power supply relay and heat generation occurs.

The CPU 10 has the abnormality detection function of detecting abnormalities of, in addition to the sensor section 8, the drive circuit 11, the inverter circuit section 3, the motor windings, and so forth based on each input information, and, when detecting an abnormality, in order to interrupt the current supply of only a predetermined phase, for example, in response to the abnormality, turns off the upper and lower switching elements 31 and 32 and the switching element 34 for a motor relay of the corresponding phase. Alternatively, it is also possible to turn off the switching element 5 for a power supply relay to interrupt the power supply itself.

The motor 2 is a brushless motor in which the three-phase windings are connected by delta connection. A rotation sensor 9 for detecting the rotation position of a rotor is mounted for the brushless motor, and the rotation information thereof is transferred to the input circuit 12 of the control circuit section 4. Instead of being a brushless motor with three-phase delta connection, the motor 2 may have star connection or may be a brush motor with two pairs of two poles. Moreover, as in the case of an existing device, distributed winding and concentrated winding can also be adopted as winding specifications.

Next, the details of the filter section 17 will be described. This filter section 17 is inserted to prevent noise by PWM control of the current of, in particular, the inverter circuit section 3 of the control unit 1 from being emitted to the outside from this device. The coil 17b is provided for noise between the lines of +B and GND and called a common mode coil, and the coil 17d is provided for noise of the +B line and called a normal mode coil. Moreover, of the capacitors, 17a and 17c are each called across the line or an X capacitor, and the capacitors 17e1 and 17e2 are each called a line bypass or a Y capacitor. The filter section 17 suppresses noise emitted by those filter elements and is called an electromagnetic interference (EMI) filter.

However, if the capacitor has a leg portion, for example, this is the equivalent of having inductance depending on the length of this leg portion and sometimes affects the effect of the filter due to the influence of residual inductance and equivalent series resistance. For this reason, the connection and placement thereof requires ingenuity; in general, a line that is connected to each element is designed so as to be as short as possible. Moreover, in order to make the length of wiring to the main bodies of, in particular, the capacitors 17a, 17c, 17e1, and 17e2 as short as possible, it is desirable to meet conductive lines themselves at capacitor connection positions, not laying out the conductive lines from the +B and GND lines to the capacitors. It is to be noted that a point 17f midway between the Y capacitors 17e1 and 17e2 is a body ground and connected, in an electrical sense, to a vehicle body (GND) via part of a main body of the motor 2.

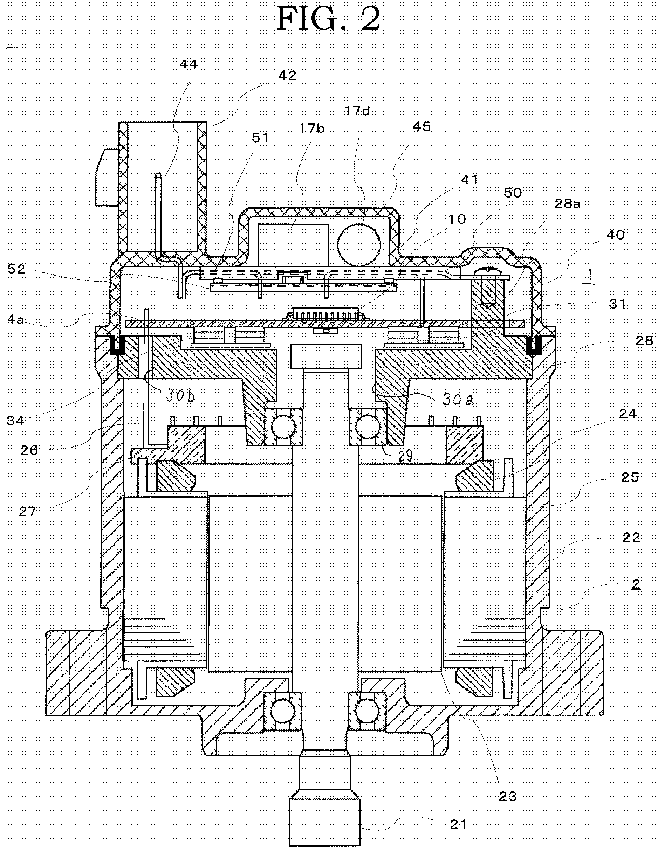

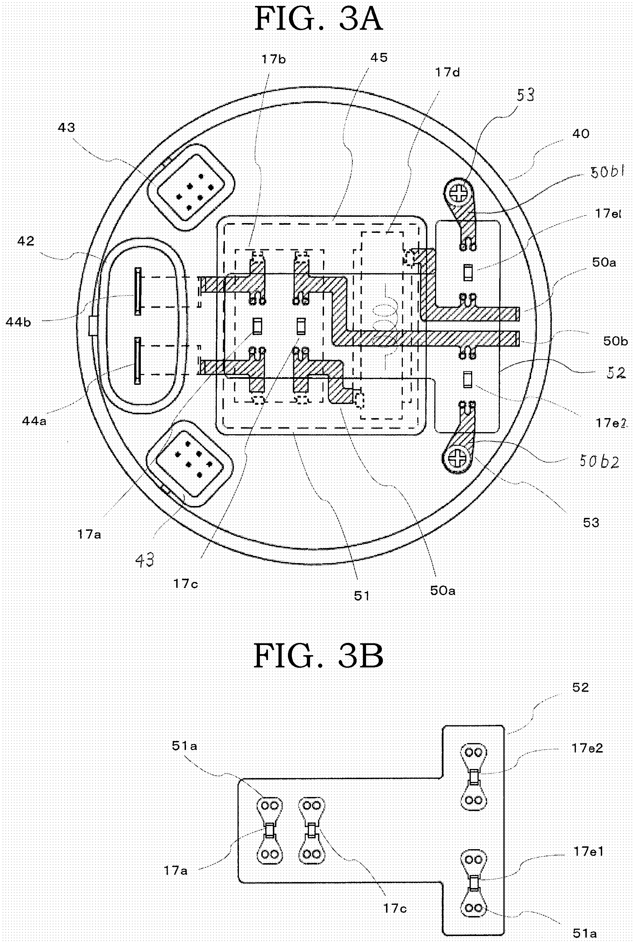

The structure of integration of the motor 2 and the control unit 1 of the device having the above-described circuits will be described by using Fig. 2 and Figs. 3A and 3B. Relatively large parts are present from the battery 6 to a control substrate 4a forming the control circuit section 4 via a connector 42 and the filter section 17 and the shapes thereof are also shapes which are not suitable for dense packaging, which hampers miniaturization. This invention is directed to improvement of the placement configuration of an area around the connector 42 and the filter section 17, which will be described in detail below.

Fig. 2 is a sectional view of the whole electric power steering device in Embodiment 1 of this invention; a lower side in the drawing is the motor 2 with an upper part with which the control unit 1 is integrated with a frame 28 interposed therebetween in such a way that the control unit 1 and a motor rotating shaft 21 are coaxially placed. The motor 2 is built into a motor case 25, and, in this motor case 25, as in the case of the existing device, around the rotating shaft 21, a rotor 23 formed of a plurality of pole pairs of permanent magnets is placed and a stator 22 around which windings 24 are wound is placed around the rotor 23 with a space left therebetween. The windings 24 of three phases are wound around the stator 22; as for an end of each phase, a ring-shaped connection ring 27 is disposed very near an upper part of the winding for connection, and, as for ends of the windings of three phases, winding ends 26 (only one of the three winding ends 26 is depicted in the drawing) which extend therefrom extend to the control unit 1. Moreover, at the boundary between the control unit 1 and the motor 2, the frame 28 is provided, and, in the center thereof, holes 30a through which a motor output shaft 21 passes with held a bearing 29, and 30b through which the winding ends 26 can pass and are provided.

The periphery of the control unit 1 is covered with a housing 40 coupled to the above-described motor case 25, roughly in the central part of the housing 40, a convex filter chamber 41 that houses the parts constituting the filter section 17 of Fig. 1 is present, and the control substrate 4a on which the control circuit section 4, which will be described later, and the like are mounted is built thereinto. In this control unit 1, in a periphery of the housing 40 near the filter chamber 41, a connector for power supply 42 is further placed. This connector for power supply 42 and the housing 40 (including an upper part 45 of the filter chamber 41) are integrally made of resin.

On the control substrate 4a, circuit parts such as the control circuit section 4 and the inverter circuit section 3 of Fig. 1 are mounted, and, in Fig. 2, the CPU 10 is mounted on the upper surface of the control substrate 4a and the switching elements 31 and 34 and the like are mounted on the lower surface of the control substrate 4a. Since the switching elements 31, 32, 34, and so forth, which supply a current to the coil windings of the motor 2, generate heat by the control, the switching elements 31, 32, 34, and so forth are configured so as to be in contact with the frame 28 so that the switching elements 31, 32, 34, and so forth can transfer heat thereto; therefore, the frame 28 also serves as a heat sink. Moreover, the coil winding ends 26 are connected to a wiring pattern or a terminal (none of which is depicted in the drawing) of the control substrate 4a and then connected to the switching elements of the inverter circuit section 3.

One of the features of this Embodiment 1 is that the filter section 17 incorporated into the filter chamber 41 is configured as a filter module into which the parts depicted in Fig. 1, that is, a plurality of bus bars 50 forming conductive lines, an insulating resin member 51, a filter substrate 52, the coils 17b and 17d, the capacitors 17a, 17c, 17e1, and 17e2, and so forth are integrated. Specifically, the bus bars 50, which are integrated with each other by the resin member 51, extend immediately below the filter chamber 41; one end of the bus bars 50 is electrically connected to an end extending from a terminal 44 (+B, GND) of the connector for power supply 42 and the other end is screw-held to a projection 28a of the frame 28. On these bus bars 50, the coils 17b and 17d are mounted as described above and electrical connection therebetween is also established.

Furthermore, below the above-described bus bars 50 and resin member 51, the filter substrate 52 is coupled, and, on this filter substrate 52, as will be described in detail later, wiring patterns are provided on the surface thereof and the capacitors 17a, 17c, 17e1, and 17e2 are mounted and electrical connection with the above-described wiring patterns is established. For instance, a plurality of bus bar pieces (not depicted in the drawing) extend from the above-described bus bars 50 toward the above-described wiring patterns and predetermined electrical connection is established. The filter substrate 52 and the bus bars 50 and the resin member 51 are integrated with each other by, for example, connecting the filter substrate 52 and the bus bars 50 and the resin member 51 by an added bus bar piece (not depicted in the drawing) or connecting the filter substrate 52 with the resin member 51 by a support column (not depicted in the drawing) projecting from the resin member 51.

Fig. 3A is a diagram of the control unit 1 viewed from the outermost side and is a partially perspective view. Fig. 3B is a top view depicting only the filter substrate 52 removed therefrom. In the outermost portion inside the housing 40, the connector for power supply 42 is placed on one outer circumferential side and two terminals: the terminals +B 44a and GND 44b are provided to stand. These two terminals are connected to bus bars 50a and 50b, respectively, which are arranged in parallel and serve as conductive lines. Between the bus bars 50a and 50b, as depicted in the circuit diagram of Fig. 1, the coils 17b and 17d are provided and electrical connection is established. The leg portions of the coils 17b and 17d and part of each of the bus bars 50a and 50b are brought into contact with each other and connected by welding, for example (a first connection).

In the filter substrate 52 of Fig. 3B, a plurality of sets of two holes 51a arranged side by side, for example, are provided, and the bus bar pieces (not depicted in the drawing) extending from the bus bars 50a and 50b are inserted thereinto and connected to the wiring patterns of the filter substrate 52 by welding, for instance (a second connection) . From this connection, the wiring patterns extend toward the capacitors 17a, 17c, 17e1, and 17e2 and are welded to the above-described capacitors. The capacitors 17a and 17c are located immediately below the coil 17b, and the above-described bus bar pieces form a connection with the above-described coil and are formed without being extended for a long distance from the main streams of the bus bars. As described above, as a result of the coil 17b placed on the above-described bus bars 50 and the capacitors 17a and 17c placed on the filter substrate 52 being connected as linearly as possible by the most direct way, it is possible to reduce residual inductance and equivalent series resistance to a minimum.

Next, a method for connecting the above-described capacitors 17e1 and 17e2 to the body ground will be described. As depicted in Fig. 3A, part of each of the bus bars 50 is extended (see 50b1 and 50b2 of Fig. 3A) and a fastening portion for a screw 53 is provided at an end thereof. Then, by fastening the above-described screws 53 and the ends of the above-described bus bars 50b1 and 50b2 to screw holes provided in the projection 28a of the frame 28 of Fig. 2, it is possible to connect the ends (intermediate connecting points) of the above-described capacitors 17e1 and 17e2 to 17f (GND) via the frame 28 of Fig. 2. The frame 28 is press-fit or swaged into the motor case 25, and the motor case 25 is attached to the vehicle body. Thus, the capacitors 17e1 and 17e2 are connected to the body ground by passing through each part.

As other parts, two sensor connectors 43 for the sensor section 8 are also placed on the periphery.

As described above, in Embodiment 1, since the filter section 17 is configured as a filter module into which the plurality of bus bars 50 serving as conductive lines, the insulating resin member 51, the filter substrate 52, the coils 17b and 17d, and the capacitors 17a, 17c, 17e1, and 17e2 are integrated and is housed and placed in the upper part of the control unit 1, the ease with which the filter section 17 is assembled is dramatically enhanced, and, since the use of the filter substrate 52 can make shorter the length of wiring from the bus bars 50, it is possible to perform the intrinsic noise suppression function of the filter sufficiently.

### Embodiment 2.

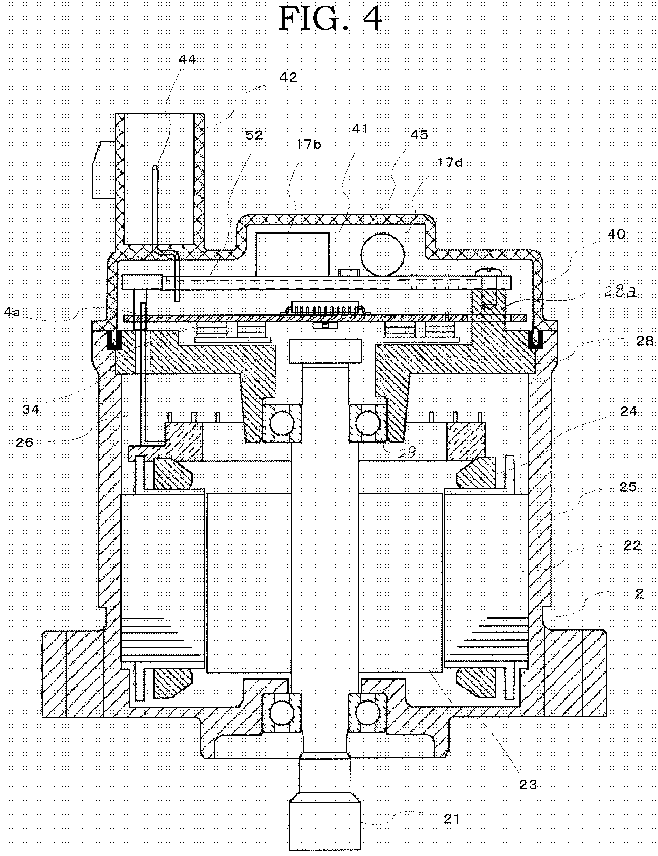

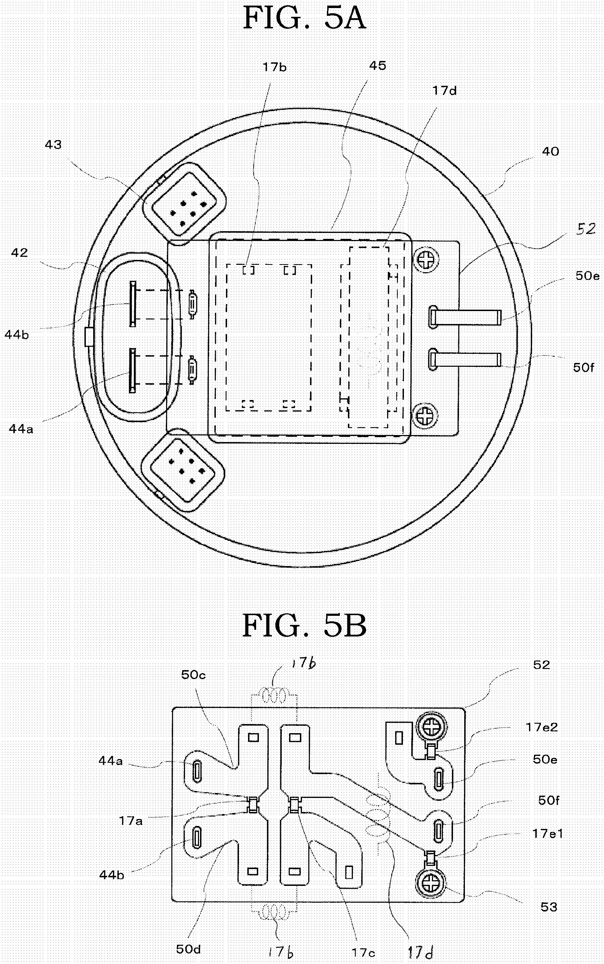

Next, Embodiment 2 will be described by using Fig. 4 and Figs. 5A and 5B. Portions equivalent to those of Embodiment 1 are identified with the same reference signs. Fig. 4 is an overall configuration sectional view of an electric power steering device, and Figs. 5A and 5B are top views depicting the internal configuration of an area around a filter module section. Since the configurations of the motor 2 and the control circuit 4 (the control substrate 4a) and the filter chamber 41 of the housing 40 of the control unit 1 are the same as those of Embodiment 1, explanations thereof will be omitted. Since Embodiment 2 differs from Embodiment 1 in the configuration of a filter module forming the filter section 17, this portion will be described below. The bus bars 50 forming the conductive lines and the insulating resin member 51 of Embodiment 1 are omitted and wiring patterns placed on the surface of the filter substrate 52 are substituted therefor. One end of this filter substrate 52 is supported by the frame 28 and the other end is screw-held to the projection 28a of the frame 28.

Furthermore, an extension of the terminal 44 of the connector for power supply 42 passes through the wiring patterns formed on the surface of the filter substrate 52 and is connected thereto by welding, for example. It is to be noted that the coils 17b and 17d and the capacitors are mounted on the filter substrate 52 and electrical connection therebetween is also established.

In addition, the detailed configuration of the filter module will be described with reference to Figs. 5A and 5B. As mentioned above, the terminals 44a and 44b of the connector for power supply 42 extend to the inside of the control unit 1 and pass through the filter substrate 52 (Fig. 5A) and are connected to the wiring patterns (50c, 50d) on the surface of the filter substrate 52 by welding, for example. As is clear from Fig. 5B, the wiring patterns 50c and 50d each have a plurality of virtually V-shaped patterns and are formed so as to extend in a symmetric manner and be connectable to the capacitor 17a and the coil 17b. The wiring patterns 50c and 50d are formed so as to be then connected to the capacitor 17c, the coil 17d, and the capacitors 17e1 and 17e2 and finally connected to terminals 50e and 50f. Though not depicted in the drawings, these terminals 50e and 50f are provided to supply power to the control substrate 4a of Fig. 4.

As described above, the filter module is configured by forming a base of the filter section 17 by using the filter substrate 52 and the wiring patterns 50c and 50d provided thereon and placing and connecting the electrical parts thereon and thereto, and the ease with which the filter section 17 is assembled is further enhanced. Moreover, from the connector terminals 44a and 44b, the wiring patterns 50c and 50d are each connected first to the capacitor 17a on one side, that is, a bent portion of the virtually V-shaped pattern and then connected to the coil 17b at an end of another side connecting to the bent portion; thus, since a configuration in which the capacitor 17a is connected only to the bent portion of the V-shaped pattern, not the main stream (total length) of the wiring pattern, is adopted, it is possible to shorten a conductive path to the capacitor and further reduce residual inductance. It is to be noted there is no need to give much consideration to inductance in distance length from the terminals 44a and 44b to the coil 17b. The reason is that a coil having inductance is inserted in series, and a slight increase in inductance in a wiring pattern causes no problem. Furthermore, the patterns 50c and 50d are placed in a nearly symmetric manner, so that the distances of connection to the +B line and the GND line become the same length.

Although the wiring patterns 50c and 50d of the filter substrate 52 are placed on one surface of the substrate as depicted in Fig. 5B, another pattern can be placed on the other surface of the filter substrate 52 and the other pattern on the other surface can also be brought into contact with the body ground by a connecting member, for example, the screw 53. By placing a power supply wiring pattern on one surface and a body ground pattern on the other surface by using the surfaces of the filter substrate 52, it is also possible to cut off emitted noise from the control substrate 4a. Moreover, as for holding of large parts such as the coils 17b and 17d, in addition to attaching a holding member to the filter substrate 52, a structure in which a part is provided with a leg in an outside diameter portion thereof and a hole into which the leg portion can be inserted is formed in the filter substrate 52 for positioning and holding can also be adopted.

As described above, since a filter module is configured by using the wiring pattern on the filter substrate 52 as a conductive line, the effects of enhancing the ease with which the filter section 17 is assembled and achieving weight reduction by reducing the number of bus bar parts are obtained.

### Embodiment 3.

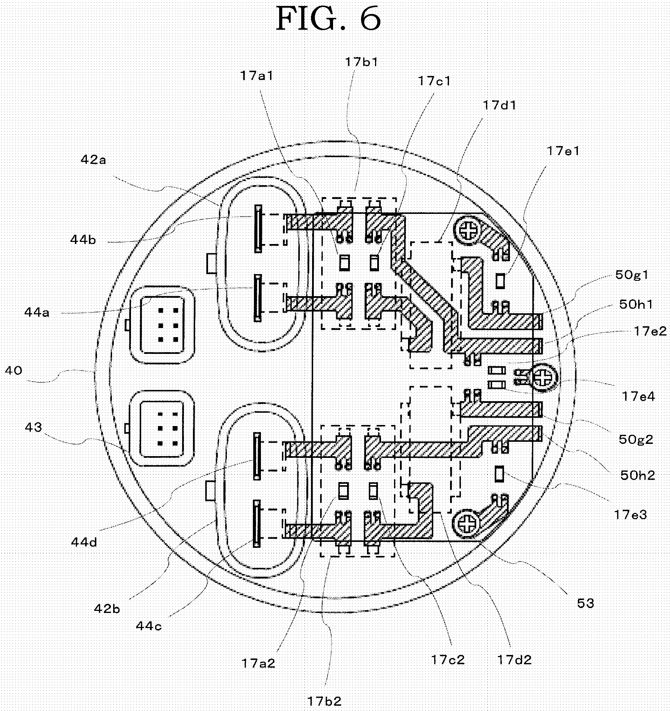

Next, Embodiment 3 will be described. Fig. 6 is a top view of a housing 40 of a control unit 1, and what is different from Embodiments 1 and 2 is that two connectors for power supply are placed and two filter sections connecting thereto are also independently placed. What is dealt with is a device having a configuration in which, in the circuit of Fig. 1, two sets of winding sets of a motor 2 are present and therefore two sets of inverter circuits are provided therefor. In order to supply a large current to such a device provided with the two sets of motor windings and the two sets of inverter circuits, two sets of connectors for power supply of input and two sets of filter sections are provided. As depicted in Fig. 6, connectors for power supply 42a and 42b are arranged in parallel, and +B and GND terminals 44a and 44b of the connector for power supply 42a and +B and GND terminals 44c and 44d of the connector for power supply 42b respectively extend and are connected to a common mode coil 17b1 and capacitors 17a1 and 17c1 and a common mode coil 17b2 and capacitors 17a2 and 17c2.

Since normal mode coils 17d1 and 17d2 use exactly the same elements, as a result of being placed and connected as depicted in Fig. 6, bus bars 50g1, 50h1, 50g2, and 50h2 forming the output terminals thereof are placed in the order of +, -, +, and -. As described above, even in a device provided with two sets of connectors and two sets of filter sections, both parts are placed in parallel and the filter sections are integrated with each other and the elements are similarly placed and connected in a symmetric manner. If the coil windings of the normal mode coils 17d1 and 17d2 are changed and the positions of the leads thereof are changed, the order of placement of the bus bars of the output terminals is + (50g1), - (50h1), - (50h2), and + (50g2). A determination as to which of the orders of placement of the bus bars is used may be made with consideration given to standardization of parts, wiring between the control substrate 4a and the inverter circuit 3, and so forth.

By integrating even two sets of + and - terminals with each other by one insulating resin member and, in addition thereto, configuring a filter substrate on which capacitors are mounted as one substrate, modularization can be achieved. Furthermore, a connector 43 for a sensor is placed in an outer circumferential position that does not interfere with the connector for power supply 42 and the filter section 17. This offers advantages of, not only the efficient placement on the upper surface of the housing 40, but also the separate placement of wiring in the control unit, such that wiring can be performed for a sensor section from the left side of Fig, 6 and for a power supply system from the right side. Moreover, connection to a body ground is established by using a screw 53. However, since Y capacitors 17e2 and 17e4 are located close to each other, connection is shared thereby.

As described above, even with a device provided with two connectors for power supply and two filter sections, by placing and connecting the connectors for power supply and the filter sections in a nearly parallel manner on the upper surface of the housing 40, miniaturization and enhancement in workability can be achieved, and, by configuring the filter section 17 as a module having two sets of each of elements, the ease with which the filter section 17 is mounted and enhancement of placement thereof are achieved.

### Reference Signs List

1 control unit, 2 motor, 3 inverter circuit section, 4 circuit control section, 4a control substrate, 5 relay for power supply, 6 battery, 8 sensor section, 9 rotation sensor, 10 CPU, 11 drive circuit, 12 input circuit, 13 power supply circuit, 17 filter section, 17a, 17c, 17e capacitor, 17b, 17d coil, 21 motor shaft, 22 motor, 24 winding, 25 motor case, 26 winding end, 27 connection ring, 28 frame, 28a projection, 40 housing, 41 filter chamber, 42 power supply connector, 44 power supply terminal, 50a, 50b, 50e, 50f, 50g, 50h bus bar (conductive line), 50c, 50d wiring pattern (conductive line), 51 resin member, 52 filter substrate, 53 screw

## Claims

1. An electric power steering device that includes an electric motor (2) rotating a steering mechanism for a vehicle and a control unit (1) placed on a counter-output side of a rotating shaft of the electric motor (2), the electric power steering device in which a connector (42) for power supply is placed in part of the control unit (1), wherein
in the control unit (1), near the connector (42) for power supply (17), a filter module into which filter parts including at least wiring for electric conduction, a coil (17b, 17d), and a capacitor (17a, 17c, 17e) are integrated is housed,
**characterized in that**
the wiring for electric conduction includes a + line and a - line for power supply which are placed in parallel,
as the coil (17b, 17d), at least one of a common mode coil and a normal mode coil is placed,
the capacitor (17a, 17c, 17e) is placed near the coil (17b, 17d), and
an area of connection between a main stream portion of the wiring for electric conduction and the coil (17b, 17d) and an area of connection between the main stream portion of the wiring for electric conduction and the capacitor (17a, 17c, 17e) are wired in a shortest distance.

2. The electric power steering device according to claim 1, wherein
the filter module is configured with a plate-like bus bar (50) that is held by an insulating resin member (51) and has one surface on which the coil (17b, 17d) is mounted and a filter substrate (52) on which the capacitor (17a, 17c, 17e) is mounted, the filter substrate (52) integrated with the bus bar (50) and the insulating resin member (51), and
the bus bar (50) includes a first connection that is connected to the coil (17b, 17d) and a second connection that is connected to the capacitor (17a, 17c, 17e) mounted on the filter substrate (52).

3. The electric power steering device according to claim 1, wherein
the filter module (17) is configured with a filter substrate (52) having one surface on which the coil (17b, 17d) is mounted and another surface on which the capacitor (17a, 17c, 17e) is mounted, and
the filter substrate (52) has a surface on which a pattern for wiring is formed and includes, in the pattern for wiring, a connection to which the coil (17b, 17d) and the capacitor (17a, 17c, 17e) are electrically connected.

4. The electric power steering device according to any one of claims 1 to 3, wherein
the capacitor (17a, 17c, 17e) is placed immediately below the coil (17b, 17d).

5. The electric power steering device according to claim 3, wherein
the pattern for wiring is formed in a shape of a letter V and, to a bent portion of the shape of the letter V, the capacitor (17a, 17c, 17e) is connected.

6. The electric power steering device according to claim 2 or 3, wherein
in a configuration in which a plurality of sets of the connectors (42) for power supply and a plurality of sets of filter sections (17) are placed in parallel, the connectors (42) for power supply are integrated with each other by one insulating resin member and the filter sections (17) are mounted on one filter substrate.

7. The electric power steering device according to claim 1, wherein
in part of the wiring for electric conduction, a body ground pattern which is electrically connected to a case of the electric motor (2) is provided.

8. The electric power steering device according to claim 7, wherein
the electric motor (2) includes a frame (28) forming a boundary with the control unit (1),
the frame (28) is brought into electric contact with the case of the electric motor (2), and
the body ground pattern is electrically and mechanically connected to part of the frame (28).

## Patentansprüche

1. Elektrische Servolenkvorrichtung, die einen Elektromotor (2), der einen Lenkmechanismus für ein Fahrzeug rotiert, und eine Steuereinheit (1), die auf einer Gegenausgangsseite einer rotierenden Welle des Elektromotors (2) angeordnet ist, umfasst, wobei in der elektrischen Servolenkvorrichtung ein Verbinder (42) zur Stromversorgung in einem Teil der Steuereinheit (1) angeordnet ist, wobei
in der Steuereinheit (1) in der Nähe des Verbinders (42) für die Stromversorgung (17) ein Filtermodul angeordnet ist, in das Filterteile integriert sind, die mindestens eine Verdrahtung zur elektrischen Leitung, eine Spule (17b, 17d) und einen Kondensator (17a, 17c, 17e) umfassen,
**dadurch gekennzeichnet, dass**
die Verkabelung für die elektrische Leitung eine + Leitung und eine - Leitung für die Stromversorgung, die parallel geschaltet sind, umfasst,
als Spule (17b, 17d) mindestens eine von einer Gleichtaktspule und einer Normalbetriebsspule angeordnet ist,
der Kondensator (17a, 17c, 17e) in der Nähe der Spule (17b, 17d) angeordnet ist, und
ein Bereich der Verbindung zwischen einem Hauptstromteil der Verdrahtung für elektrische Leitung und der Spule (17b, 17d) und ein Bereich der Verbindung zwischen dem Hauptstromteil der Verdrahtung für elektrische Leitung und dem Kondensator (17a, 17c, 17e) in kürzestem Abstand verdrahtet sind.

2. Die elektrische Servolenkvorrichtung nach Anspruch 1, wobei
das Filtermodul mit einer plattenartigen Sammelschiene (50) ausgebildet ist, die durch ein isolierendes Harzelement (51) gehalten wird und eine Oberfläche aufweist, auf der die Spule (17b, 17d) angeordnet ist, sowie ein Filtersubstrat (52), auf dem der Kondensator (17a, 17c, 17e) angeordnet ist, wobei das Filtersubstrat (52) mit der Sammelschiene (50) und dem isolierenden Harzelement (51) integriert ist, und
die Sammelschiene (50) eine erste Verbindung umfasst, die mit der Spule (17b, 17d) verbunden ist, und eine zweite Verbindung, die mit dem Kondensator (17a, 17c, 17e) verbunden ist, der auf dem Filtersubstrat (52) angeordnet ist.

3. Die elektrische Servolenkvorrichtung nach Anspruch 1, wobei
das Filtermodul (17) mit einem Filtersubstrat (52) mit einer Oberfläche, auf der die Spule (17b, 17d) angeordnet ist, und einer anderen Oberfläche, auf der der Kondensator (17a, 17c, 17e) angeordnet ist, ausgebildet ist, und
das Filtersubstrat (52) eine Oberfläche aufweist, auf der ein Muster für die Verdrahtung ausgebildet ist, und in dem Muster für die Verdrahtung eine Verbindung umfasst, mit der die Spule (17b, 17d) und der Kondensator (17a, 17c, 17e) elektrisch verbunden sind.

4. Die elektrische Servolenkvorrichtung nach einem der Ansprüche 1 bis 3, wobei
der Kondensator (17a, 17c, 17e) unmittelbar unter der Spule (17b, 17d) angeordnet ist.

5. Die elektrische Servolenkvorrichtung nach Anspruch 3, wobei
das Muster für die Verdrahtung in Form eines Buchstabens V gebildet ist und an einen gebogenen Abschnitt der Form des Buchstabens V der Kondensator (17a, 17c, 17e) angeschlossen ist.

6. Die elektrische Servolenkvorrichtung nach Anspruch 2 oder 3, wobei
in einer Konfiguration, in der eine Vielzahl von Sätzen der Verbinder (42) zur Stromversorgung und eine Vielzahl von Sätzen von Filterabschnitten (17) parallel angeordnet sind, wobei die Verbinder (42) zur Stromversorgung durch ein isolierendes Harzelement miteinander integriert sind und die Filterabschnitte (17) auf einem Filtersubstrat angeordnet sind.

7. Elektrische Servolenkvorrichtung nach Anspruch 1, wobei
in einem Teil der Verkabelung für die elektrische Leitung ein Körperschutzmuster bereitgestellt wird, das elektrisch mit einem Gehäuse des Elektromotors (2) verbunden ist.

8. Die elektrische Servolenkvorrichtung nach Anspruch 7, wobei
der Elektromotor (2) einen Rahmen (28) umfasst, der eine Grenze mit der Steuereinheit (1) bildet,
der Rahmen (28) in elektrischen Kontakt mit dem Gehäuse des Elektromotors (2) gebracht wird, und
das Erdungsmuster des Körpers elektrisch und mechanisch mit einem Teil des Rahmens (28) verbunden ist.

## Revendications

1. Dispositif de direction assistée électrique qui inclut un moteur électrique (2) faisant tourner un mécanisme de direction pour un véhicule et une unité de commande (1) placée sur un côté de contre-sortie d'un arbre tournant du moteur électrique (2), le dispositif de direction assistée électrique dans lequel un connecteur (42) pour une alimentation en courant est placé dans une partie de l'unité de commande (1), dans lequel
dans l'unité de commande (1), près du connecteur (42) pour une alimentation en courant (17), un module de filtre dans lequel des parties de filtre incluant au moins un câblage pour une conduction électrique, une bobine (17b, 17d) et un condensateur (17a, 17c, 17e) sont intégrés est abrité,
**caractérisé en ce que**
le câblage pour une conduction électrique inclut une ligne + et une ligne - pour une alimentation en courant qui sont placées en parallèle,
quant à la bobine (17b, 17d), au moins une d'une bobine en mode commun et d'une bobine en mode normal est placée,
le condensateur (17a, 17c, 17e) est placé près de la bobine (17b, 17d), et
une zone de connexion entre une portion de flux principal du câblage pour une conduction électrique et la bobine (17b, 17d) et une zone de connexion entre la portion de flux principal du câblage pour une conduction électrique et le condensateur (17a, 17c, 17e) sont câblées dans une distance la plus courte.

2. Dispositif de direction assistée électrique selon la revendication 1, dans lequel
le module de filtre est configuré avec une barre omnibus (50) du type plaque qui est maintenue par un élément en résine isolante (51) et présente une surface sur laquelle la bobine (17b, 17d) est montée et un substrat de filtre (52) sur lequel le condensateur (17a, 17c, 17e) est monté, le substrat de filtre (52) étant intégré à la barre omnibus (50) et à l'élément en résine isolante (51), et
la barre omnibus (50) inclut une première connexion qui est connectée à la bobine (17b, 17d) et une seconde connexion qui est connectée au condensateur (17a, 17c, 17e) monté sur le substrat de filtre (52).

3. Dispositif de direction assistée électrique selon la revendication 1, dans lequel
le module de filtre (17) est configuré avec un substrat de filtre (52) présentant une surface sur laquelle la bobine (17b, 17d) est montée et une autre surface sur laquelle le condensateur (17a, 17c, 17e) est monté, et
le substrat de filtre (52) présente une surface sur laquelle un schéma pour câblage est formé et inclut, dans le schéma pour câblage, une connexion à laquelle la bobine (17b, 17d) et le condensateur (17a, 17c, 17e) sont connectés électriquement.

4. Dispositif de direction assistée électrique selon l'une quelconque des revendications 1 à 3, dans lequel
le condensateur (17a, 17c, 17e) est placé immédiatement en dessous de la bobine (17b, 17d).

5. Dispositif de direction assistée électrique selon la revendication 3, dans lequel
le schéma pour câblage est formé sous un aspect d'une lettre V et, à une portion courbée de l'aspect de la lettre V, le condensateur (17a, 17c, 17e) est connecté.

6. Dispositif de direction assistée électrique selon la revendication 2 ou 3, dans lequel
dans une configuration dans laquelle une pluralité d'ensembles des connecteurs (42) pour une alimentation en courant et une pluralité d'ensembles de sections de filtre (17) sont placés en parallèle, les connecteurs (42) pour une alimentation en courant sont intégrés les uns aux autres par un élément en résine isolante et les sections de filtre (17) sont montées sur un substrat de filtre.

7. Dispositif de direction assistée électrique selon la revendication 1, dans lequel
dans une partie du câble pour conduction électrique, un schéma de terre de carrosserie qui est connecté électriquement à un carter du moteur électrique (2) est prévu.

8. Dispositif de direction assistée électrique selon la revendication 7, dans lequel
le moteur électrique (2) inclut une carcasse (28) formant une limite avec l'unité de commande (1),
la carcasse (28) est mise en contact électrique avec le carter du moteur électrique (2), et
le schéma de terre de carrosserie est connecté électriquement et mécaniquement à une partie de la carcasse (28).
